# EUROPEAN PATENT SPECIFICATION

(11) **EP 1 107 455 B1**
(45) Date of publication and mention of the grant of the patent: **27.09.2006**
(21) Application number: 00126431.6
(22) Date of filing: 06.12.2000
(51) Int. Cl.: H03L 1/02

(54) **Temperature compensated oscillator and method of controlling it**
Temperaturkompensierter Oszillator und zugehöriges Regelungsverfahren
Oscillateur à compensation thermique et méthode pour le controler

(30) Priority: 06.12.1999 JP 34649999; 07.08.2000 JP 2000239003
(43) Date of publication of application: 13.06.2001
(73) Proprietor: SEIKO EPSON CORPORATION, Shinjuku-ku, Tokyo 163-0811 (JP)
(72) Inventor: Oka, Manabu, Suwa-shi, Nagano-ken 392-8502 (JP)
(74) Representative: Hoffmann, Eckart

(56) References cited:
- EP-A- 0 299 674
- DE-A- 4 431 172
- US-A- 4 061 979
- US-A- 5 389 899
- US-A- 5 874 864

## Description

This invention relates to a temperature compensated oscillator according to claim 1, a method of controlling it, and a wireless communication device using it. US 5874864 shows the features of the preamble of claim 1.

Conventionally, as oscillator used for electronic equipment, such as wireless communication devices, a temperature compensated oscillator (TCXO) is used because the frequency of the output signals needs to be stable over a wide temperature range. The oscillation frequency of a piezoelectric resonator changes according to the capacity of the load to the resonator. The temperature compensated oscillator utilizes this fact to maintain the frequency constant through a temperature compensation (TC) circuit causing the load capacity to vary according to temperature variations.

Among such oscillators, there are analog ones, where the TC circuit is an analog circuit, and digital ones, where the TC circuit is a digital circuit. (All references to simply "oscillator" in the following text mean "temperature compensated oscillator" unless specified otherwise.)

In an analog oscillator, because the TC circuit consists of many resistor elements and semiconductor elements, noise Vn, such as thermal noise, shot noise, etc., is added to the temperature compensation (TC) voltage Vc1 output by the TC circuit.

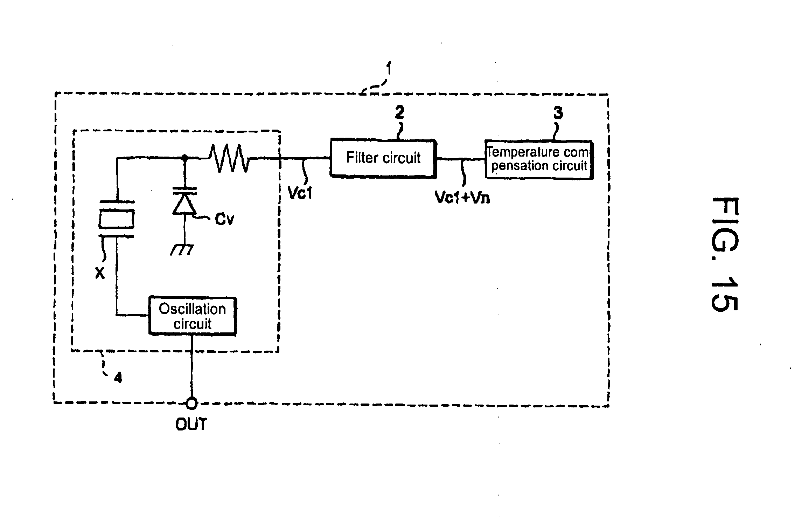

Therefore, in the analog oscillator shown in Fig. 15, by inserting a filter circuit 2, that removes the high-frequency components, between a TC circuit 3 and a voltage controlled oscillation circuit 4, such noise Vn can be removed from the output voltage (Vc1 + Vn) of the TC circuit 3. In this way, by installing the filter circuit 2 that removes noise contained in the TC voltage output from the TC circuit 3, phase noise of the output signal is reduced.

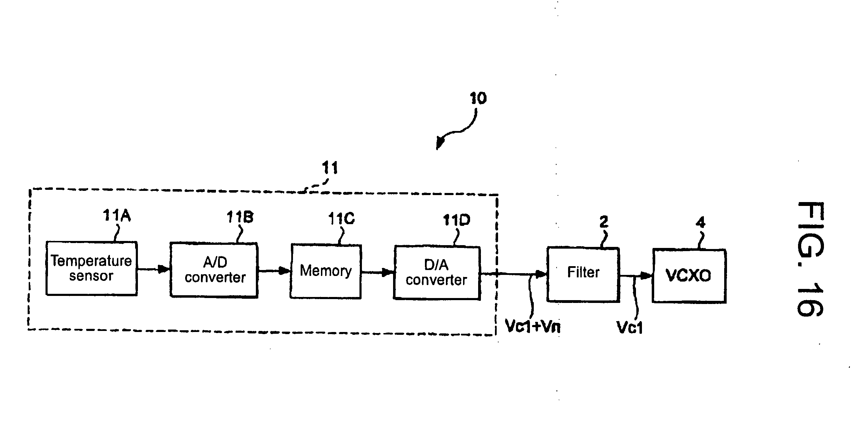

Fig. 16 is a block diagram of a digital oscillator. In the digital oscillator 10, a TC circuit 11 consists, for example, of a temperature sensor 11A, an ADC (analog-to-digital converter) 11B, a memory 11C, and a DAC (digital-to-analog converter) D.

In the TC circuit 11, temperature information, measured by the temperature sensor 11A, is converted from analog to digital form by the ADC 11B, further converted to a digital signal for compensating the temperature dependency of a piezoelectric resonator X, and output as TC voltage Vc1. The digital signal for compensating the temperature dependency of the piezoelectric resonator X has been stored in advance in the memory 11C.

In this case, if any change occurs in the digital signal input to the D/A converter 11D, due to a temperature change, step-shape noise Vn occurs in the TC voltage Vc1 due to influence of resolution of the DAC 11D. Because of this, as shown in Fig. 16, by inserting the filter circuit 2 that removes the high-frequency components, between the TC circuit 11 and the voltage controlled oscillation circuit (VCXO) 4, noise Vn is removed from the TC voltage Vc1. Therefore, by using a filter circuit such as an analog one, in a digital oscillator, phase noise of the output signal can be reduced.

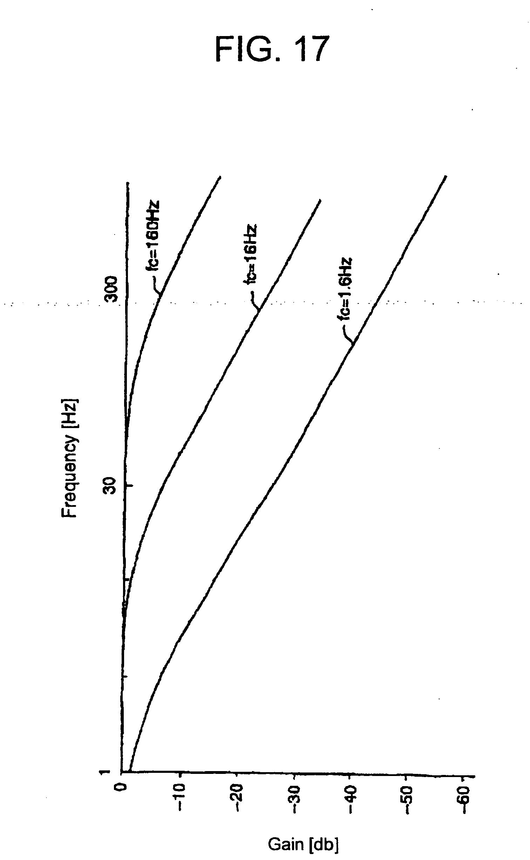

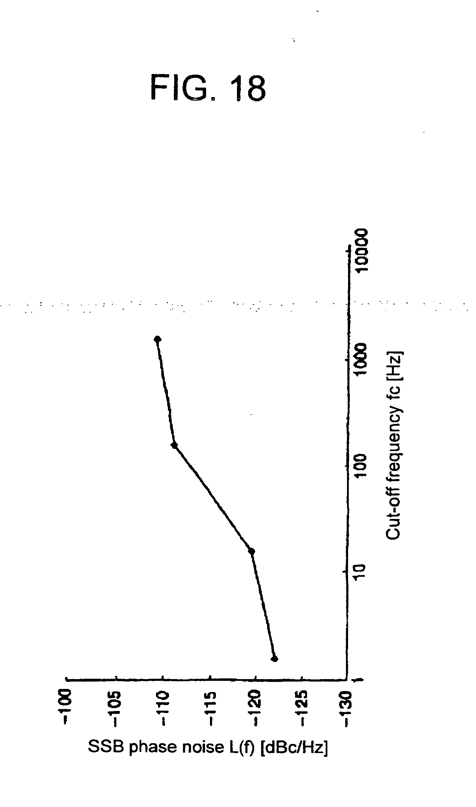

As is illustrated by the characteristic curves of a low pass filter circuit (LPF) in Fig. 17, the larger the time constant, namely the lower the cut-off frequency fc, the more are high frequency components attenuated. Because of this, for reducing phase noise of output signals of a temperature compensated oscillator using a filter circuit, the cut-off frequency fc of the filter circuit should be relatively low. Shown in Fig. 18 is a characteristic curve between the SSB phase noise at the detuning frequency and the cut-off frequency fc of a filter circuit.

On the other hand, when power is supplied intermittently to such an oscillator, for example, to save power during a standby time in a portable wireless communication device, the transitional time from the start of oscillation until the output frequency becomes stable (called "oscillation starting time" below) should be as short as possible.

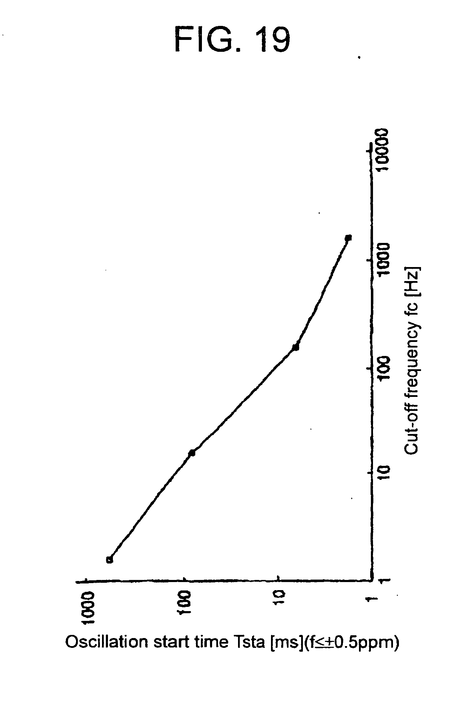

However, as illustrated by the characteristic curve of the oscillation starting time in Fig. 19, the lower the cut-off frequency of the filter circuit is, the longer the oscillation starting time Tsta becomes. Because of this, in an oscillator, there is a problem that realization of both reduction of phase noise of the output signal and reduction of the oscillation starting time is difficult.

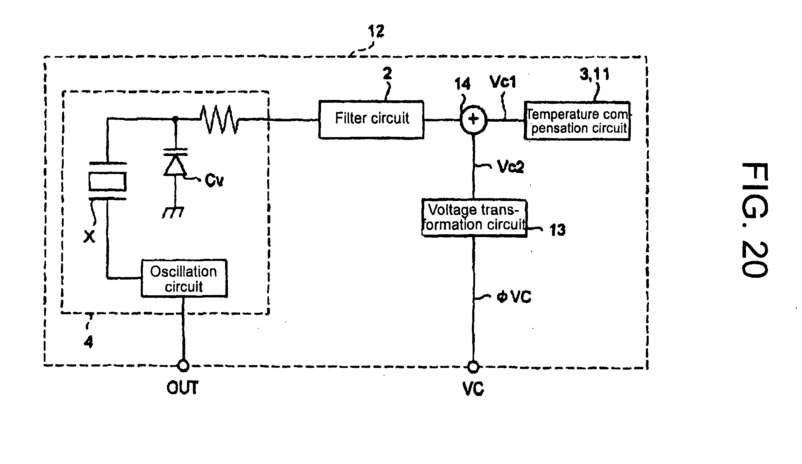

As shown in Fig. 20, as an oscillator of modern portable wireless communication devices, a VC-TCXO is often used that is equipped with a frequency control signal input terminal VC for the AFC function that adjusts the frequency even more precisely based on a signal from the base station.

Namely, as shown in Fig. 20, VC-TCXO 12 receives a frequency control signal φVC supplied from a signal processing circuit of a portable wireless communication device based on the signal received from the base station, and converts the voltage of this frequency control signal φVC to a frequency control voltage Vc2 by a voltage conversion circuit 13.

Then, in VC-TCXO 12 the frequency control voltage Vc2 and the TC voltage Vc1 are added by an adder 14, and the result is supplied to a voltage controlled oscillation circuit 4 via the filter circuit 2. By this, the frequency of the output signal is temperature compensated and changed to a frequency synchronous to the base frequency of the base station.

In the circuit described above, if phase noise of the output signal is reduced by using a filter circuit 2 with a large time constant, a problem also occurs in that the response of the oscillation frequency to the frequency control voltage Vc2 is not good.

EP 0299674 A2 discloses a frequency synthesizer with a power-down mode in which the synthesizer circuitry and the VCO are switched off.

US 5,389,899 discloses a frequency synthesizer including a phase-locked loop. The phase locked loop effects phase comparison between a comparison signal based on an output from a voltage-controlled oscillator and a reference signal based on an output from a reference oscillator. The resultant phase difference signal is submitted to a loop filter whose output serves as a control signal of the voltage-controlled oscillator. The frequency synthesizer includes a low pass filter having switches for changing the time constant of the filter.

It is an object of the invention to provide a temperature compensated oscillator capable of both showing reduced power consumption and fast and noise-free control responsiveness, also when powering-up. Another objective is to provide a method of controlling the oscillator and a wireless communication device equipped with the oscillator.

These objects are achieved with a temperature compensated oscillator as claimed in claims 1, a method as claimed in claim 15 and a communication device as claimed in claim 14. Preferred embodiments of the invention are subject-matter of the dependent claims.

The present invention solves the problem caused by a great time constant of the filter circuit for removing noise from the TC voltage by employing switching means for temporarily bypassing the filter circuit or reducing its time constant when the oscillation is started. This allows to reduce the transitional period until the oscillator reaches its steady state to be reduced substantially.

Further objects and advantages of the present invention will be more readily understood from the following detailed description of preferred embodiments in conjunction with the accompanying drawings, in which:
- Fig. 1: is a block diagram of an oscillator;
- Fig. 2: shows an example of a switch in the oscillator;
- Fig. 3: is a characteristic curve used to explain the voltage conversion circuit in the oscillator;
- Fig. 4: is circuit diagram of an example of the voltage controlled oscillation circuit;
- Fig. 5: is circuit diagram of another example of the voltage controlled oscillation circuit;
- Fig. 6: is a timing chart of the operation of the oscillator;
- Fig. 7: is a block diagram of an oscillator according to the embodiment of the invention;
- Fig. 8: shows an example of a switch in the oscillator;
- Fig. 9: is a further block diagram of an oscillator;
- Fig. 10: is a block diagram of a portable wireless communication device using the oscillator;
- Fig. 11: is a timing chart of the operation of the oscillator;
- Fig. 12: is a block diagram of an oscillator including an embodiment of the invention;
- Fig. 13: is a perspective view of an oscillator;

- Fig. 14: is a further perspective view of an oscillator;
- Fig. 15: is a block diagram of a conventional analog oscillator;
- Fig. 16: is block diagram of a conventional digital oscillator;
- Fig. 17: is a characteristic curve of the filter circuit (LPF);
- Fig. 18: is a characteristic curve of SSB phase noise of the output signal of the oscillator;
- Fig. 19: is a characteristic curve of the oscillation starting time of the output signal of the oscillator; and
- Fig. 20: is a block diagram of a VC-TCXO having a filter circuit is inserted.

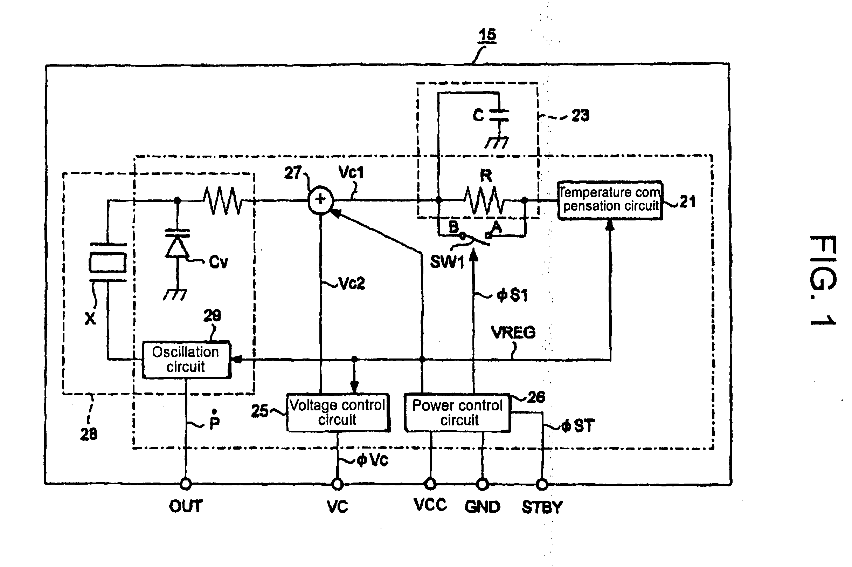

Shown in Fig. 1 is a block diagram of a temperature compensated oscillator (simply referred to as "oscillator").

This oscillator 15 has a temperature compensation (TC) circuit 21, a filter circuit 23, a switch SW1 connected in parallel to the filter circuit 23, a voltage control circuit 25, a power control circuit 26, an adder 27, and a voltage controlled oscillation (VCO) circuit 28.

The TC circuit 21 can be one that outputs a temperature compensation (TC) voltage Vc1 to cancel any change in frequency caused by a temperature dependency of a piezoelectric resonator X. For example, the TC circuit 21, described above with reference to the prior art, can be constructed with a temperature sensor, an ADC circuit, a memory, and a DAC circuit. After converting temperature information into a digital signal, it is converted to data suitable for temperature compensation that is prestored in the memory, and the temperature compensation circuit 11 may be of a digital type that outputs a TC voltage Vc1 by converting the data for temperature compensation from digital to analog, or of an analog type that outputs a TC voltage Vc1 by utilizing the temperature dependency of elements such as a thermistor.

The filter circuit 23 is a low-pass filter consisting of resistor elements and capacitors (capacitance elements), or inductance elements and capacitors, and removes the high-frequency components of the TC voltage Vc1, namely noise contained in the TC voltage Vc1.

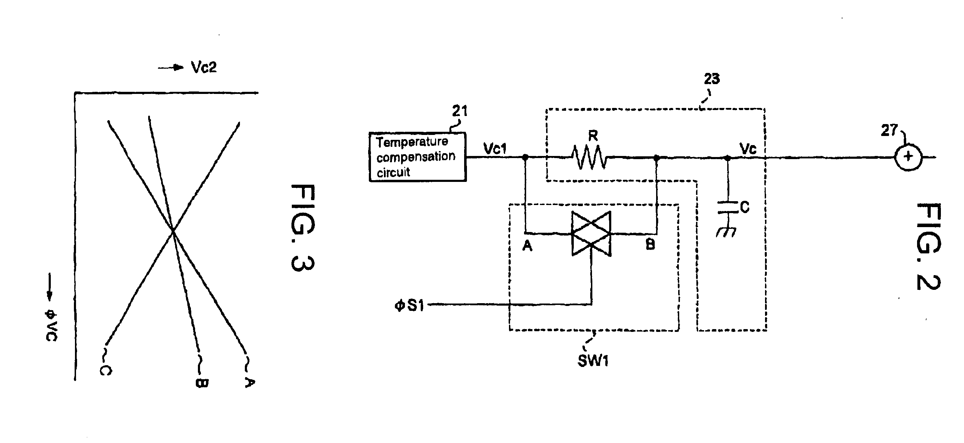

Because the switch SW1 is connected in parallel to this filter circuit 23, when the switch SW1 is in the ON state, the TC voltage Vc1 does not go through the filter circuit 23 but is passed through the switch SW1. Fig. 2 is a circuit diagram of the switch SW1 surroundings when this switch SW1 is an analog switch.

The voltage control circuit 25 is a circuit, that a voltage conversion circuit of the conventional VC-TCXO-type (13 shown in Fig. 20), etc., can be applied to, and that generates the frequency control voltage Vc2 based on the frequency control signal φVC supplied via the frequency control voltage input terminal VC.

For example, the voltage control circuit 25 is a circuit by which the inclination of the frequency control voltage Vc2 relative to the frequency control signal φVC characteristic is changed or the polarity of the change in the frequency control voltage Vc2 is changed, as shown by A, B, and C in Fig. 3.

The adder 27 adds the TC voltage Vc1, supplied via the filter circuit 23, and the frequency control voltage Vc2, and outputs the result to the VCO circuit 28.

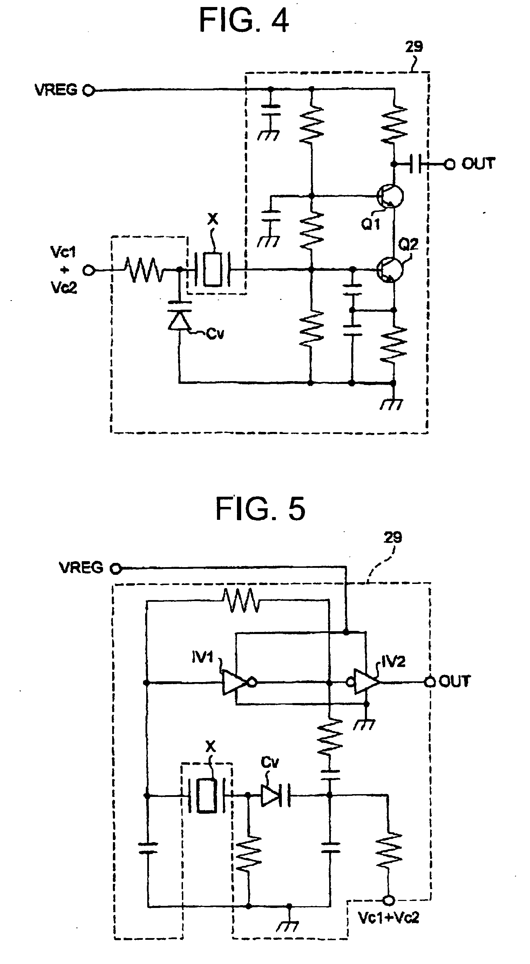

The VCO circuit 28 is composed of an oscillation circuit 29 that oscillates a piezoelectric resonator X, such as a quartz crystal resonator, a ceramic resonator, etc. and a buffer circuit, and a variable capacitance element Cv. The VCO circuit 28 may be constructed using bipolar transistors Q1 and Q2 as shown in Fig. 4, or it may be a CMOS-type where an inverter IV is composed of MOS-type transistors as shown in Fig. 5.

The VCO circuit 28 is controlled so that the frequency of the output signal P remains constant due to the TC voltage Vc1 even if the temperature changes. It is also controlled so that the frequency of the output signal P is made the frequency set by the frequency control voltage Vc2.

In Fig. 1, the power control circuit 26 is a circuit that controls the power supply to the TC circuit 21, the voltage control circuit 25, and the oscillation circuit 29; it controls the power supply to the individual circuits based on the standby control signal φST supplied externally via the standby control terminal STBY. This power control circuit 26 is provided with power from an external power source via the power terminals VCC and GND.

The power control circuit 26 causes an output signal of a desired frequency to be put out by having the TC voltage Vc1 and the frequency control voltage Vc2 supplied to the VCO circuit 28 when the externally supplied standby control signal φST is at the H level.

The power control circuit 26 stops action of each circuit when externally supplied standby control signal φST is at the L level. Namely, by stopping power supply to the TC circuit 21, the voltage control circuit 25, and the oscillation circuit 29, power consumption of the oscillator 15 can be reduced.

Furthermore, the power control circuit 26 changes the switch SW1 to the ON state by setting the switch control signal φS1 to the H level for a short time synchronized with a rise of the externally supplied standby control signal φST.

Therefore, when the standby control signal φST assumes the H level, the TC voltage Vc1 is output via the switch SW1 without going through the filter circuit 23.

Because of this, when the standby control signal φST rises to the H level, the TC voltage Vc1 is supplied to the VCO circuit 28 in a short time by avoiding the delay time caused by going through the filter circuit 23 that has a relatively large time constant.

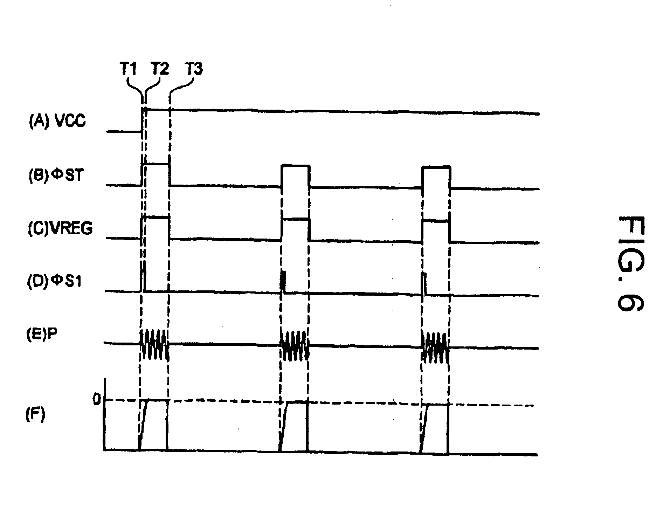

Figure 6 is a timing chart of the oscillator 15, and actions of the oscillator 15 are explained by referring to this figure. The supply voltage is applied to the power terminal VCC of oscillator 1 5 from time T1 as shown in Fig. 6 (A), and assumed is the case where the standby control signal φST is supplied to the standby control terminal STBY as shown in Fig. 6 (B).

First of all, if the standby control signal φST rises to the H level at time T1, the power control circuit 26 starts to supply a supply voltage VREG to each circuit, and the TC circuit 21, the voltage control circuit 25, the oscillation circuit 29, and the adder 27 start operating.

Also, when the standby control signal φST assumes the H level, as shown in Fig. 6 (D), because the switching control signal φS1 rises to the H level for a short period in synchronization with the rise of the standby control signal φST, the TC circuit 21 is short-circuited via the switch SW1.

Because of this, in the oscillator 15, the rise time of the TC voltage Vc1 can be reduced compared with the case where the TC voltage Vc1 is supplied via the filter circuit 23 to the VCO circuit 28, and the frequency control of the output signal P, by the TC voltage Vc1, can be started in a short time.

Also, once the supply voltage VREG is supplied to the voltage control circuit 25 at time T1, the voltage control circuit 25 outputs the frequency control voltage Vc2 based on the frequency control signal φVC, and by the frequency control voltage Vc2 being supplied via the adder 27 to the VCO circuit 28, frequency control of the output signal is started.

Next, as shown in Fig. 6 (D), once the switch control signal φS1 reaches the L level at time T2, because the switch SW1 goes to the OFF state, the TC voltage Vc1 is supplied via the filter circuit 23 to the VCO circuit 28. Therefore, when the switch SW1 goes to the OFF state, noise contained in the TC voltage Vc1 is removed.

The oscillator 15 can reduce phase noise of the output signal P by removing noise contained in the TC voltage Vc1 using the filter circuit 23.

Once the standby control signal φST reaches the L level at time T3, as shown in Fig. 6 (B), supply of supply voltage VREG to each circuit by the power control circuit 26 is stopped as shown in Fig. 6 (C), and actions of the TC circuit 21, the voltage control circuit 25, the oscillation circuit 29, and the adder 27 are stopped. In this way, the oscillator 15 can reduce power consumption by starting or stopping output of the output signal P based on the standby control signal φST.

Let the desired frequency of the output signal P, that this oscillator 15 should output, be denoted as f0 and the difference between this desired frequency f0 and the actual frequency (the frequency of the signal actually output) be denoted as df. The oscillator 15 can stabilize the frequency of the output signal P to the desired frequency f0 within a short time once the standby control signal φST rises.

Also, the oscillator 15 has the switch SW1 in parallel to the filter circuit 23, and can stabilize the frequency of the output signal P to the desired frequency within a short time by setting the switch SW1 to the ON state for a short time once the standby control signal φST rises.

In this way, the oscillator 15 can reduce phase noise of the output signal and also stabilize the output signal frequency within a short time.

By the way, in an actual implementation of this oscillator 15, a value of about -120 [dBc/Hz] could be obtained at the offset frequency of 100 [Hz] as the phase noise property.

### Embodiment of the invention

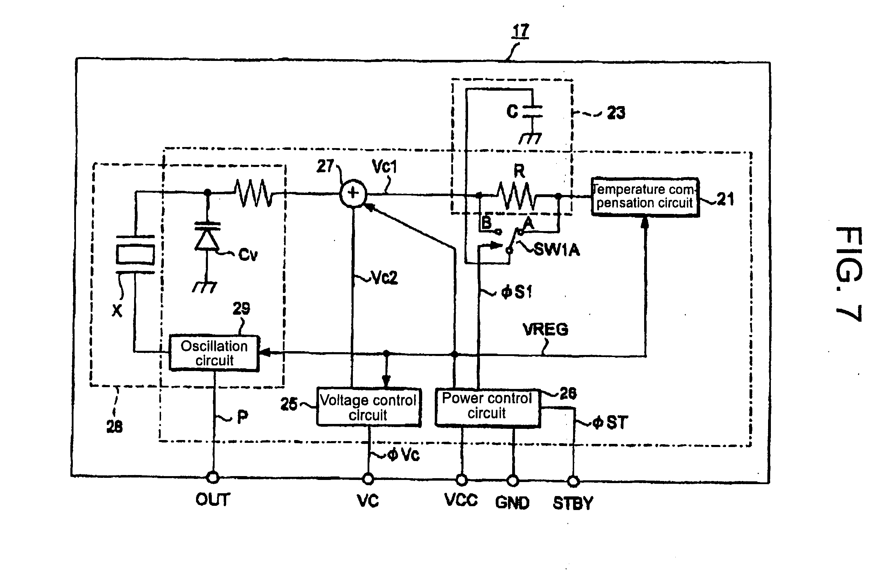

Shown in Fig. 7 is a block diagram of a temperature compensated oscillator 17 according to the embodiment of this invention.

Because this oscillator 17 has the same construction as the oscillator 15 of Fig.1, except that a switch SW1A is different, the same parts are indicated using the same reference signs, and duplicate explanations are omitted.

In this oscillator 17, the switch SW1A is for connecting one end of a capacitor C of the filter circuit 23 to either a terminal A or a terminal B. Terminal A is connected to the TC circuit 21 side (TC voltage input side) of the resistor element R, while terminal B is connected to the adder 27 side (TC voltage output side) of the resistor element R.

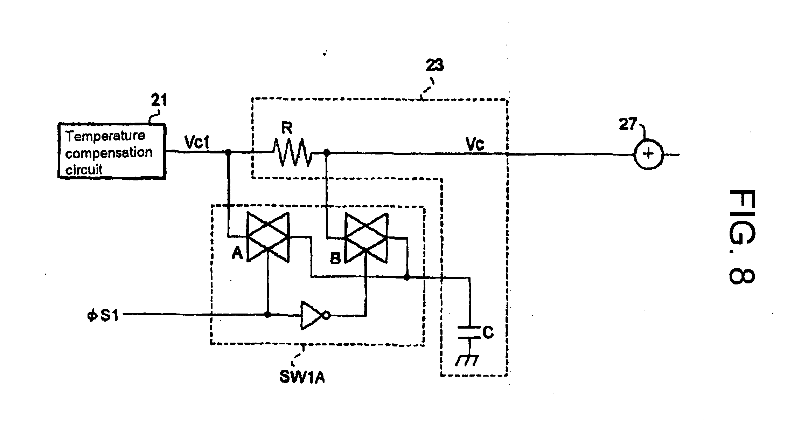

Switch SW1A is constructed to connect the capacitor C to the terminal A, when the switch control signal φS1 is at the H level, and to the terminal B, when the switch control signal φS1 is at the L level; as shown in Fig. 8, this may be realized with two analog switches, one being controlled by the signal φS1 to become ON if signal φS1 is an H-level signal while the other analog switch is controlled by the inverted signal φS1 to become ON if signal φS1 is an L-level signal.

Next, actions of this oscillator 17 are explained. Because the timing chart of this temperature compensated oscillator 17 is almost the same as that of the oscillator 15, explanation is given to the parts whose actions are different by using Fig. 6 as a reference.

In this oscillator 17, once the standby control signal φST reaches the H level at time T1 as shown in Fig. 6 (B), the switch control signal φS1 reaches the H level for a short period synchronized with the rise of the standby control signal φST as shown in Fig. 6 (D), and the one end of the capacitor C of the filter circuit 23 is switched from the terminal B to the terminal A only for a short period.

Therefore, oscillation starting time delay due to recharging of the capacitor C caused by the resistor R is reduced. In other words, in the oscillator 17, after the one end of the capacitor C is switched from the terminal A to the terminal B, delay of the TC voltage Vc1 due to a relatively large time constant of the filter circuit 23 can be reduced.

In an actual implementation of oscillator 17, a value of about -121 [dBc/Hz] could be obtained at the offset frequency of 100 [Hz] as the phase noise property.

### Further oscillator examples

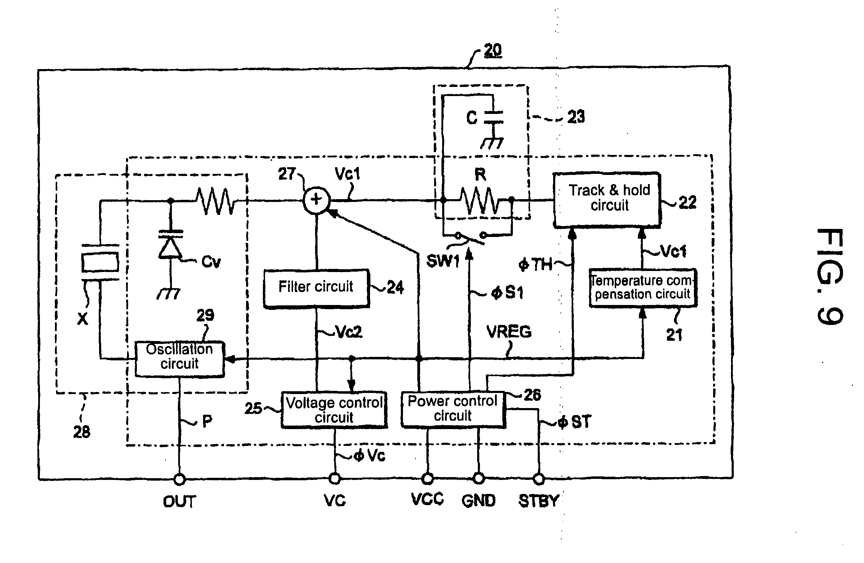

Shown in Fig. 9 is a block diagram of a temperature compensated oscillator 20.

Because the oscillator 20 has the same construction as the oscillator 15 of Fig. 1, except that a filter circuit 24 and a track & hold circuit 22 are added, the same parts are indicated with the same reference signs, and duplicated explanations are omitted.

The track & hold circuit 22 switches between a track mode (first mode) and a hold mode (second mode) according to the mode control signal φTH supplied from the power control circuit 26, and outputs the input voltage as it is by passing it through as the output voltage in the track mode; in the hold mode, the circuit 22 keeps the input voltage at the time of mode switch and outputs it as output voltage. In the case of the circuit shown in Fig. 9, the track & hold circuit 22 switches to the track mode when the mode control signal φTH is at the H level, and to the hold mode when the mode control signal φTH is at the L level. This track & hold circuit 22 may be constructed using a well-known circuit. As the simplest basic construction, considered is a circuit constructed using a switch circuit that changes to the ON position when the mode control signal φTH is at the H level, and a capacitor that retains the output voltage when the switch circuit changes to the OFF position.

The filter circuit 23 is a low-pass filter, in this example, consisting of resistor elements and capacitors (capacitor elements), or inductance elements and capacitors, and it removes the high-frequency components of the TC voltage Vc1 received via the track & hold circuit 22. Namely, when the track & hold circuit 22 is in the track mode, because the output voltage is the TC voltage Vc1 output from the TC circuit 22, it removes noise contained in the TC voltage Vc1.

Because the switch SW1 is connected in parallel to this filter circuit 23, when the switch SW1 is in the ON state, the TC voltage Vc1 output from the track & hold circuit 22 is passed through the switch SW1 without going through the filter circuit 23.

To the voltage control circuit 25 the conventional VC-TCXO voltage conversion circuit (13, shown in Fig. 20) etc. can be applied, and it is a circuit that produces the frequency control voltage Vc2 based on the frequency control signal φVC supplied via the frequency control voltage input terminal VC.

The filter circuit 24 is a low-pass filter consisting of resistor elements and capacitance elements for example, and removes the high-frequency components of the frequency control voltage Vc2 supplied from the voltage control circuit 25. Therefore, the filter circuit 24 removes noise contained in the frequency control voltage Vc2 such as noise contained in the frequency control signal φVC supplied externally to the frequency control voltage input terminal VC, noise inside the voltage control circuit 25, etc.

Because the filter circuit 24 can remove noise contained in the frequency control voltage Vc2, if the cut-off frequency is set in the range of several 100 Hz to several kHz, filter circuits with relatively small time constants may be used.

On the other hand, the filter circuit 23 needs to have a cut-off frequency in the range of several 10 Hz to several 100 Hz for removing noise contained in the TC voltage Vc1. Because of this, filter circuit 23 has a lower cut-off frequency fc than filter circuit 24.

In Fig. 9, the power control circuit 26 controls the power supply to individual circuits based on the standby control signal φST supplied externally via the standby terminal STBY, and also switches the track & hold circuit 22 to the track mode or the hold mode by outputting the mode control signal φTH based on the standby control signal φST as stated above.

Namely, the power control circuit 26 supplies the supply voltage VREG to each circuit when the standby control signal φST is at the H level, and also sets the mode control signal φTH to the H level to switch the track & hold circuit 22 to the track mode.

On the other hand, the power control circuit 26 stops supply of the supply voltage VREG when the standby control signal φST is at the L level, and also sets the mode control signal φTH to the L level to switch the track & hold circuit 22 to the hold mode.

Therefore, the power control circuit 26 causes an output signal of a desired frequency to be output by having the TC voltage Vc1 and the frequency control voltage Vc2 supplied to the VCO circuit 28 when the externally supplied standby control signal φST is at the H level.

The power control circuit 26 stops actions of individual circuits when the externally supplied standby control signal φSt is at the L level. Namely, by stopping power supply to the circuits, except for the power control circuit 26 itself and the track & hold circuit 22, power consumption of the oscillator 20 can be reduced.

At this time, because the track & hold circuit 22 goes into the hold mode, it maintains the output voltage at the level the TC voltage Vc1 had at the time of switching modes. Because of this, once the externally supplied standby control signal φST goes to the H level and the track & hold circuit 22 is switched to the track mode, it can immediately output the TC voltage Vc1 from the TC circuit 21 without a delay.

Furthermore, the power control circuit 26 sets the switch SW1 to the ON state for a short period by setting the switch control signal φS1 to the H level for a short period in synchronization with the rise of the externally supplied standby control signal φST.

Therefore, once the standby control signal φST goes to the H level, the TC voltage Vc1 output via the track & hold circuit 22 is output via the switch SW1 without going through the filter circuit 23.

Because of this, the standby control signal φST goes to the H level, and Vc1 is supplied to the VCO circuit 28 within a short time by avoiding a delay time caused by going through the filter circuit 23 that has a relatively large time constant.

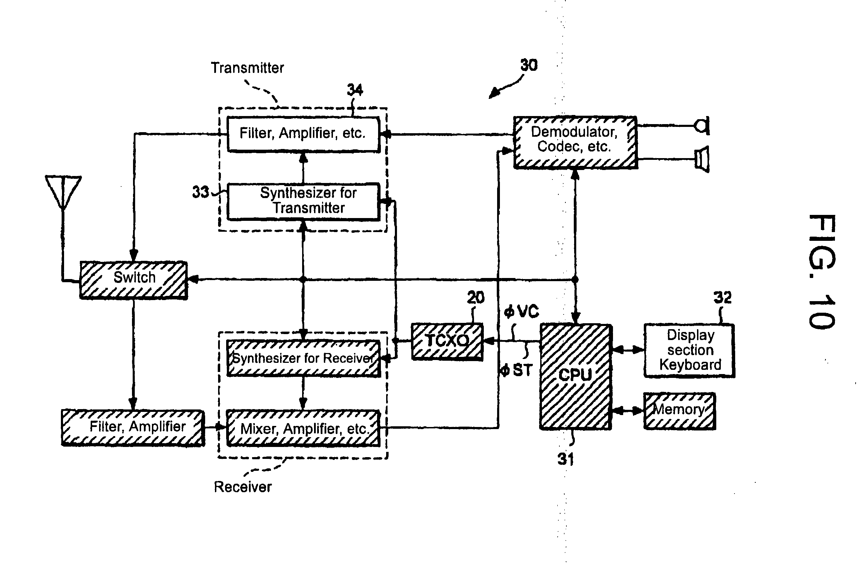

Figure 10 is a block diagram showing this oscillator 20 applied to a portable wireless communication device 30. This communication device 30 may be a conventional communication device except that the oscillator 20 differs from the conventional one and the central processing unit (CPU) 31 outputs the standby control signal φST to the standby control terminal STBY of the oscillator 20.

The shaded parts in Fig. 10 are the parts that operate intermittently for reducing the power consumption in the standby state of this communication device 30.

Although these parts performing an intermittent operation are the same as in the conventional communication device, this communication device 30 can directly control whether the oscillator 20 should be driven according to the standby control signal φST.

The display/keyboard section 32 is always driven so that it can always accept input by the user, and the sending synthesizer 33 and the sending filter/amplifier section 34 are driven only when sending.

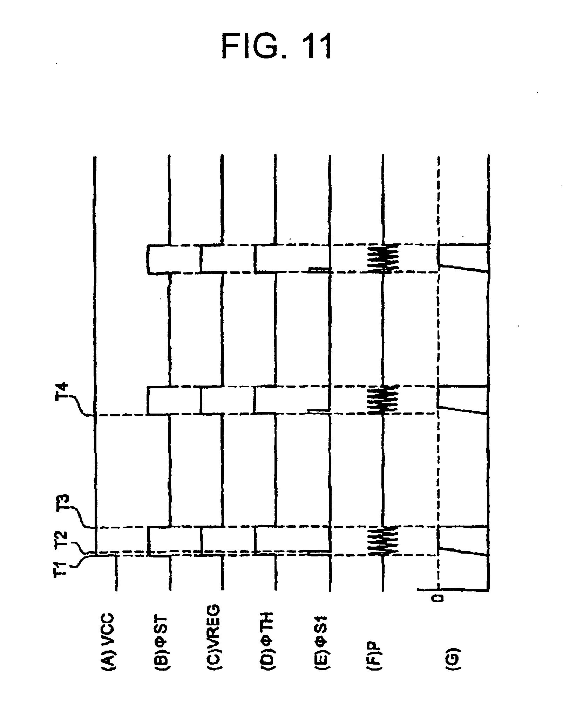

Figure 11 is a timing chart of the oscillator 20, and explanation is given on the actions of the oscillator 20 by referring to this figure. The oscillator 20 is provided with supply voltage to the power terminal VCC from time T1 as shown in Fig. 11 (A), and assumed is a case where the standby control signal φST is supplied to the standby control terminal STBY as shown in Fig. 1 (B).

First of all, once the standby control signal φST reaches the H level at time T1, the power control circuit 26 starts supplying supply voltage VREG to each circuit as shown in Fig. 11 (C), and the TC circuit 21, the voltage control circuit 25, the oscillation circuit 29, and the adder 27 start operating.

Once the standby control signal φST reaches the H level, because the mode control signal φTH φTH reaches the H level as shown in Fig. 11 (D), the track & hold circuit 22 switches to the track mode. By this, the TC voltage Vc1 supplied from the TC circuit 21 can be output at once without being delayed by the track & hold circuit 22.

Furthermore, because the switching control signal φS1 reaches the H level for a short period in synchronization with the rise of the standby control signal φST, as shown in Fig. 11 (E), the filter circuit 23 is short-circuited via the switch SW1.

Because of this, in the oscillator 20, the initial TC voltage Vc1 that is supplied to the VCO circuit 28 is much nearer to the steady state TC voltage Vc1 than would be the case if the TC voltage Vc1 would have to pass through the filter circuit 23 and/or there were no track & hold circuit; thus, frequency control of the output signal P by the TC voltage Vc1 can be started within a short time.

Then, once the supply voltage VREG is supplied to the voltage control circuit 25 at time T1, the voltage control circuit 25 outputs the frequency control voltage Vc2 based on the frequency control signal φVc. This frequency control voltage Vc2 has its noise removed by the filter circuit 24 and is supplied to the VCO circuit 28 via the adder 27.

As stated above, because the cut-off frequency fc of this filter circuit 24 is relatively high, the time constant is relatively small, and the frequency control voltage Vc2 is supplied to the VCO circuit 28 with almost no delay by the filter circuit 24.

Therefore, the oscillator 20 can start frequency control of the output signal by the frequency control voltage Vc2 within a short time without sacrificing frequency control response to the change of the frequency control voltage Vc2 even if noise of the frequency control voltage Vc2 is removed using the filter circuit 24.

Next, as shown in Fig. 11 (E), once the switching control signal φS1 assumes the L level at time T2, because the switch SW1 goes to the OFF state, the TC voltage Vc1 is supplied via the filter circuit 23 to the VCO circuit 28. When the switch SW1 goes to the OFF state, noise contained in the TC voltage Vc1 is removed.

By this, the oscillator 20 can reduce phase noise of the output signal P by removing noise contained in the TC voltage Vc1 and the frequency control voltage Vc2 by the filter circuits 23 and 24, respectively.

Once the standby control signal φST reaches the L level at time T3 as shown in Fig. 11 (A), supply of supply voltage VREG by the power control circuit 26 to each circuit is stopped, and the TC circuit 21, the voltage control circuit 25, the oscillation circuit 29, and the adder 27 stop operating.

In this way, the oscillator 20 can reduce power consumption by starting or stopping output of the output signal P based on the standby control signal φST.

As shown in Fig. 11 (D), because the mode control signal φTH reaches the L level at time T3, the track & hold circuit 22 switches to the hold mode, and the output voltage of the track & hold circuit 22 is maintained at the level of the TC voltage Vc1 at the mode switching time. When the standby control signal φST reaches the H level again at T4, the TC voltage Vc1 supplied from the TC circuit 21 can be output at once without a delay by the track & hold circuit 22.

Letting the desired frequency of the output signal P that the oscillator 20 should output be denoted as f0 and the difference between the actual frequency of the actually output signal and the desired frequency f0 be denoted as df, the frequency deviation df/f0 is shown in Fig. 11 (G). The oscillator 20 can stabilize the frequency of the output signal P to the desired frequency f0 within a short time once the standby control signal φST has risen.

The oscillator 20 has the switch SW1 in parallel to the filter circuit 23, and can stabilize the frequency of the output signal P to the desired frequency within a short time by turning the switch SW1 ON for a short time once the standby control signal φST has risen.

In this way, the oscillator 20 can reduce phase noise of the output signal further, by installing the filter circuit 24, and also stabilizing the output signal frequency within a short time by installing the track & hold circuit 22.

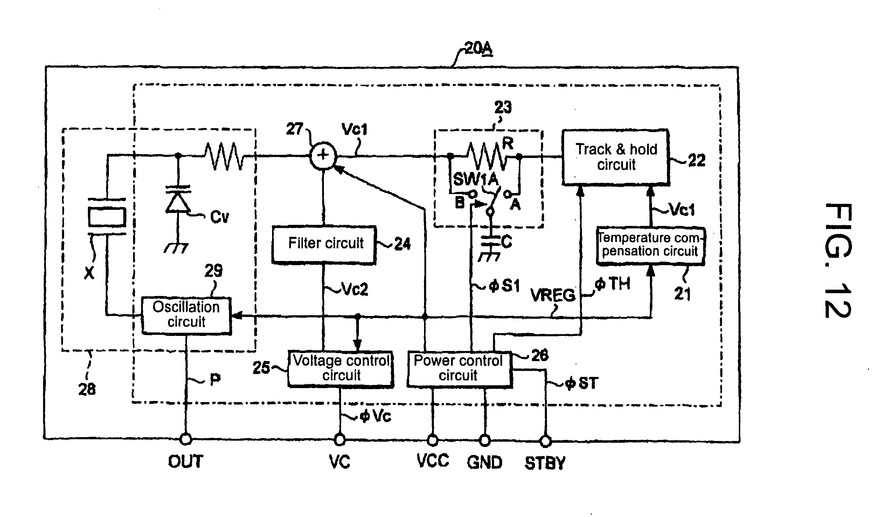

Shown in Fig. 12 is a block diagram of a temperature compensated oscillator 20A.

Because this oscillator 20A has the same construction as the oscillator 20 of Fig. 9, except that the switch SW1A is different, the same parts are indicated with the same reference signs, and duplicated explanations are omitted.

Also, because the timing chart of the oscillator 20A is almost the same as that of the oscillator 20, only parts where their actions are different are explained using Fig. 11 as a reference.

In the oscillator 20A, the switch SW1A is for switching one end of the capacitor C in the filter circuit 23 between a terminal A and a terminal B. Terminal A is connected to the track & hold circuit 22 side (TC voltage input side) of the resistor element R and terminal B is connected to the adder 27 side (TC voltage output side) of the resistor element R.

Therefore, in the oscillator 20A, as shown in Fig. 11 (E), when the switch control signal φS1 reaches the H level for a short period in synchronization with the rise of the standby control signal φST, that one end of the capacitor C is switched from the terminal B to the terminal A only for a short period, and oscillation starting time delay due to a recharging time for the capacitor C caused by the resistor R is reduced.

Although no mentioning was made about the mounting condition of the component parts forming the temperature compensated oscillator in the above, because the oscillator can remove noise contained in the TC voltage Vc1 or the frequency control voltage Vc2, elements etc., composing the oscillator can be integrated.

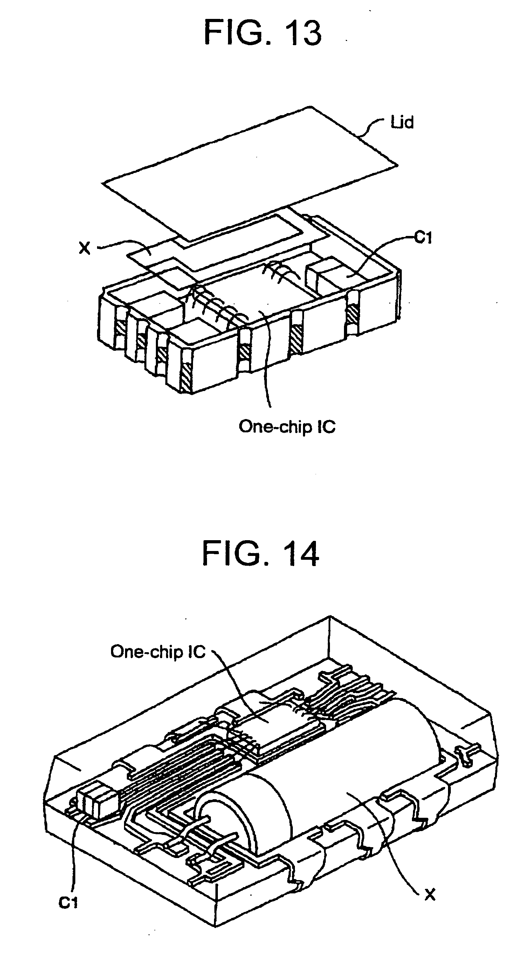

Therefore, component parts, excluding the piezoelectric resonator X of the VCO circuit 28 and the capacitor C of the filter circuit 23, (a section surrounded with an alternate long and short dash line in Fig. 1, Fig. 7, Fig. 9, and Fig. 12), or component parts, excluding only the piezoelectric resonator X (a section surrounded with an alternate long and short dash line including a variable capacity element in Fig. 4 and Fig. 5), can be constructed as a one-chip IC, for example. A temperature compensated oscillator in a ceramic package sealed with a piezoelectric resonator X between the oscillator and a lid can be constructed as shown in Fig. 13. A temperature compensated oscillator with a plastic package having a one-chip IC, the piezoelectric resonator X, and the variable capacity element Cv sealed by molding can be constructed as shown in Fig. 14.

Although a one-chip IC is connected to a board by wire bonding in Fig. 13 and Fig. 14, it is needless to say that other methods, such as flip chip bonding (FCB) can be applied. In the same way, component elements such as reactance elements of the filter circuit 23 or the filter circuit 24 can be mounted to the capacitor C. Even if the capacitor C is mounted on the exterior of the package in Fig. 13 and Fig. 14 the function of the circuit does not change.

By this, the oscillator can be miniaturized, and the number of assembling process steps and manufacturing cost can be reduced by reducing the number of parts.

Although the filter circuits 23 and 24 in the structures described above each form a single-stage low-pass filter, and it may be constructed with a multiple-stage low-pass filter for one or both of the two filter circuits.

In this case, in the oscillators 17 and 20A of the Fig 7 and 12, respectively, the respective one end of all the capacitors contained in the multiple-stage low-pass filter may be switched by the switch (SW1A) to the TC circuit side of the respective resistor or inductance element contained in the multiple-stage low-pass filter, at the start of oscillation.

Although it has been described so far with reference to structures that change the output signal frequency based on the frequency control signal φVC, it may be applied to a temperature compensated oscillator that is not equipped with a frequency control voltage input terminal VC and that maintains the output signal frequency constant even if temperature changes.

In this case, the voltage control circuit 25, the filter circuit 24, and the adder 27 may be omitted in the oscillator in each of the preceding structures. Even in this case, phase noise of the output signal can be reduced, and the output signal frequency can be stabilized within a short time.

A case where the oscillator is applied to a portable wireless communication device has been described. Any of the oscillators described above can be applied to a portable wireless communication device but can can also be used as temperature compensated oscillators in a wide variety of other electronic equipment.

As stated above, in the temperature compensated oscillator of the invention, the switching circuit is connected in parallel to the filter circuit with a large time constant so that the TC voltage can be supplied to the VCO circuit without going through the filter circuit when oscillation starts, phase noise of the output signal can be reduced by recharging the capacitor in the filter circuit, and also the output signal frequency can be stabilized within a short time without deteriorating the control response.

## Claims

1. A temperature compensated oscillator comprising:
a voltage controlled oscillation circuit (28) for generating an oscillation output signal whose frequency changes according an applied control voltage (Vc1, Vc2);
a temperature compensation circuit (21) for outputting a temperature compensation voltage (Vc1) for keeping said frequency constant irrespective of temperature changes;
filter means (23) for removing noise contained in the temperature compensation voltage (Vc1); and
power control means (26) for controlling the power supply to said temperature compensation circuit (21),
**characterized by**
said power control means (26) being adapted to also control the power supply to said voltage controlled oscillation circuit (28); and
switching means (SW1A) responsive to the power control means (26) starting to supply power to said voltage controlled oscillation circuit (28) for temporarily switching, for a specified period, from a first state to a second state, said switching means (SW1, SW1A), in said second state, changing the characteristic of said filter means (23) such that the signal delay caused by said filter means is substantially smaller than it is in the first state of said switching means (SW1, SW1A),
wherein said filter means (23) is a low pass filter having a capacitance element (C) and a resistor (R), said capacitance element (C) is connectable via said switching means (SW1A) in the first state to one end (B) of the resistor (R) and in the second state to the other end (A) of the resistor (R).

2. The oscillator of claim 1, wherein said switching means (SW1) comprises a switch connected in parallel with said filter means (23), said first state being the OFF state and said second state being the ON state of said switch.

3. The oscillator of claim 1, wherein said filter means comprises plural stages of low-pass filters in which capacitance elements are connected to resistor elements via said switching means, and said switching means is adapted to connect, in its first state, one end of each capacitance element to the temperature compensation voltage output side of the corresponding resistor element and, in its second state, to the temperature compensation voltage input side of that resistor element, among all resistor elements, that is closest to said temperature compensation circuit (21).

4. The oscillator of Claim 1 or 3, wherein inductance elements are used in place of said resistor elements (R) in said filter means (23).

5. The oscillator of any one of Claims 1 to 4, further comprising
output switching means (22) between said temperature compensation circuit (21) and said filter means (23), said output switching means (22) being adapted to switch between a first mode, in which its output voltage follows the temperature compensation voltage (Vc1), and a second mode, in which the output voltage is maintained at the level of the temperature compensation voltage (Vc1) at the time the first mode is switched to the second mode, said output switching means (22) being controlled by said power control means (26) into said first mode when power supply to said temperature compensation circuit (21) is started, and to said second mode, when power supply to said temperature compensation circuit (21) is stopped.

6. The oscillator of any one of the preceding claims, further comprising
a voltage control circuit (25) responsive to an externally supplied frequency control signal (φVC) for outputting a frequency control voltage (Vc2), said frequency control signal (φVC) representing a desired frequency of said oscillation output signal;
an adder (27) for adding said temperature compensation voltage (Vc1) and said frequency control voltage (Vc2) together to obtain said control voltage (Vc1, Vc2); and
further filter means (24) for removing noise contained in said frequency control voltage (Vc2).

7. The oscillator of claim 6, wherein the cut-off frequency of said filter means (23) is lower than that of said further filter means (24).

8. The oscillator of claims 6 or 7, wherein said further filter means (24) consists of resistor elements and capacitance elements (C) or consists of inductance elements and capacitance elements.

9. The oscillator of any one of the preceding claims, wherein said power control means (26) is adapted to control said power supply to said voltage controlled oscillation circuit (28) and said temperature compensation circuit (21) based on an externally supplied control signal (φST).

10. The oscillator of any one of the preceding claims, wherein said power control means (26) is adapted to start the power supply to said voltage controlled oscillation circuit (28) and said temperature compensation circuit (21) at the same time, and also to stop the power supply to these two circuits at the same time.

11. The oscillator of any one of the preceding claims, wherein said voltage controlled oscillation circuit (28) comprises a piezoelectric resonator (X) and a variable capacitance element (Cv) whose capacity changes according to said control voltage (Vc1, Vc2).

12. The oscillator of claim 11, wherein the component parts making up the oscillator, except for said piezoelectric resonator (X), are constructed as a one-chip IC.

13. The oscillator of claim 12, wherein said one-chip IC and said piezoelectric resonator (X) are housed in one package.

14. A wireless communication device **characterized by** containing the oscillator (20) of Claim 13 and its operation is based on the output signal of said voltage controlled oscillation circuit (28).

15. A method of controlling the temperature compensated oscillator as defined in any one of Claims 1 to 5, comprising:
(a) detecting the start of power supply to said voltage controlled oscillation circuit (28),
(b) causing said switching means (SW1, SW1A) to switch to said second state in response to a detection in step (a), and
(c) causing said switching means (SW1, SW1A) to switch back to said first state when a specified time period has passed after the switching means (SW1, SW1A) has switched to said second state in step (b).

16. The method of claim 15 for controlling the oscillator as defined in Claim 5, further comprising:
(d) detecting the start of power supply to said temperature compensation circuit (21),
(e) causing said output switching means (22) to switch to said second mode in response to a detection in step (d),
(f) detecting the power supply to said temperature compensation circuit (21) being stopped, and
(g) causing said output switching means (22) to switch back to said first mode in response to a detection in step (f).

17. A method of controlling the temperature compensated oscillator as defined in claim 5, comprising:
(d) detecting the start of power supply to said temperature compensation circuit (21),
(e) causing said output switching means (22) to switch to said second mode in response to a detection in step (d),
(f) detecting the power supply to said temperature compensation circuit (21) being stopped, and
(g) causing said output switching means (22) to switch back to said first mode in response to a detection in step (f).

18. The method of claim 16 or 17, wherein, when the power supply to said temperature compensation circuit (21) is stopped, the power supply to other circuits of said oscillator, including said voltage controlled oscillation circuit (28) but except for said output switching means (22), is also stopped.

19. The method of any one of claims 15 to 18, wherein the power supply to said voltage controlled oscillation circuit (28) and said temperature compensation circuit (21) is started and stopped in accordance with an externally supplied control signal (φST).

## Patentansprüche

1. Temperaturkompensierter Oszillator, mit:
einer spannungsgesteuerten Oszillatorschaltung (28) zum Erzeugen eines Schwingungsausgangssignals, dessen Frequenz sich entsprechend einer angelegten Steuerspannung (Vc1, Vc2) ändert;
einer Temperaturkompensationsschaltung (21) zur Ausgabe einer Temperaturkompensationsspannung (Vc1), um diese Frequenz ungeachtet der Temperaturänderungen konstant zu halten;
einem Filtermittel (23), um in der Temperaturkompensationsspannung (Vc1) enthaltenes Rauschen zu entfernen; und
einer Stromversorgungssteuereinrichtung (26) zur Steuerung der Stromversorgung der Temperaturkompensationsschaltung (21),
**gekennzeichnet durch**
die Stromversorgungssteuereinrichtung (26), die so ausgeführt ist, dass sie auch die Stromversorgung der spannungsgesteuerten Oszillatorschaltung (28) steuert; und
ein Schaltmittel (SW1A), das auf die mit der Stromversorgung der spannungsgesteuerten Oszillatorschaltung (28) beginnende Stromversorgungssteuereinrichtung (26) anspricht, um vorübergehend für eine vorgegebene Zeitspanne von einem ersten Zustand in einen zweiten Zustand umzuschalten, wobei die Schaltmittel (SW1, SW1A) im zweiten Zustand die Kennlinie des Filtermittels (23) so ändern, dass die **durch** das Filtermittel verursachte Signalverzögerung wesentlich kürzer ist als im ersten Zustand der Schaltmittel (SW1, SW1A),
wobei das Filtermittel (23) ein Tiefpassfilter mit einem kapazitiven Element (C) und einem Widerstand (R) ist und das kapazitive Element (C) im ersten Zustand über das Schaltmittel (SW1A) mit einen Ende (B) des Widerstands (R) und im zweiten Zustand mit dem anderen Ende (A) des Widerstands (R) verbunden werden kann.

2. Oszillator nach Anspruch 1, bei dem das Schaltmittel (SW1) einen Schalter aufweist, der parallel zu dem Filtermittel (23) geschaltet ist, wobei der erste Zustand der AUS-Zustand und der zweite Zustand der EIN-Zustand des Schalters ist.

3. Oszillator nach Anspruch 1, bei dem das Filtermittel mehrere Stufen Tiefpassfilter aufweist, in denen kapazitive Elemente über das Schaltmittel mit Widerstandselementen verbunden sind, und das Schaltmittel so ausgeführt ist, dass es in seinem ersten Zustand ein Ende jedes kapazitiven Elements mit der Ausgabeseite der Temperaturkompensationsspannung des entsprechenden Widerstandselements und in seinem zweiten Zustand mit der Eingabeseite der Temperaturkompensationsspannung dieses Widerstandselements verbindet, das unter sämtlichen Widerstandselementen dasjenige ist, das sich der Temperaturkompensationsschaltung (21) am nächsten befindet.

4. Oszillator nach Anspruch 1 oder 3, bei dem induktive Elemente anstelle der Widerstandselemente (R) im Filtermittel (23) verwendet werden.

5. Oszillator nach einem der Ansprüche 1 bis 4, ferner aufweisend:
ein Ausgangsschaltmittel (22) zwischen der Temperaturkompensationsschaltung (21) und dem Filtermittel (23), wobei das Ausgangsschaltmittel (22) so ausgeführt ist, dass es zwischen einem ersten Modus, in dem seine Ausgangsspannung der Temperaturkompensationsspannung (Vc1) nachläuft, und einem zweiten Modus, in dem die Ausgangsspannung auf dem Wert der Temperaturkompensationsspannung (Vc1) zum Zeitpunkt, in dem der erste Modus auf den zweiten Modus wechselt, umschaltet, wobei das Ausgangsschaltmittel (22) von der Stromversorgungssteuereinrichtung (26) in den ersten Modus gesteuert wird, wenn die Stromversorgung der Temperaturkompensationsschaltung (21) beginnt, und in den zweiten Modus, wenn die Stromversorgung zur Temperaturkompensationsschaltung (21) beendet wird.

6. Oszillator nach einem der vorigen Ansprüche, ferner aufweisend:
eine Spannungssteuerschaltung (25), die auf ein extern bereitgestelltes Frequenzsteuersignal (φVC) zur Ausgabe einer Frequenzsteuerspannung (Vc2) anspricht, wobei das Frequenzsteuersignal (φVC) eine gewünschte Frequenz des Schwingungsausgangssignals repräsentiert;
ein Addierglied (27) zum Addieren der Temperaturkompensationsspannung (Vc1) und der Frequenzsteuerspannung (Vc2), um die Steuerspannung (Vc1, Vc2) zu erhalten; und
ein weiteres Filtermittel (24) zum Entfernen von in der Frequenzsteuerspannung (Vc2) enthaltenem Rauschen.

7. Oszillator nach Anspruch 6, bei dem die Grenzfrequenz des Filtermittels (23) niedriger ist als die des weiteren Filtermittels (24).

8. Oszillator nach Anspruch 6 oder 7, bei dem das weitere Filtermittel (24) aus Widerstandselementen und kapazitiven Elementen (C) oder aus induktiven Elementen und kapazitiven Elementen besteht.

9. Oszillator nach einem der vorigen Ansprüche, bei dem die Stromversorgungssteuereinrichtung (26) so ausgeführt ist, dass sie die Stromversorgung der spannungsgesteuerten Oszillatorschaltung (28) und der Temperaturkompensationsschaltung (21) auf Basis eines extern bereitstellten Steuersignals (φST) steuert.

10. Oszillator nach einem der vorigen Ansprüche, bei dem die Stromversorgungssteuereinrichtung (26) so ausgeführt ist, dass sie die Stromversorgung der spannungsgesteuerten Oszillatorschaltung (28) und der Temperaturkompensationsschaltung (21) gleichzeitig beginnt und die Stromversorgung dieser beiden Schaltungen auch gleichzeitig beendet.

11. Oszillator nach einem der vorigen Ansprüche, bei dem die spannungsgesteuerte Oszillatorschaltung (28) einen piezoelektrischen Resonator (X) und ein Element mit variabler Kapazität (Cv) aufweist, dessen Kapazität sich entsprechend der Steuerspannung (Vc1, Vc2) ändert.

12. Oszillator nach Anspruch 11, bei dem die den Oszillator bildenden Bauteile mit Ausnahme des piezoelektrischen Resonators (X) als ein Ein-Chip-IC aufgebaut sind.

13. Oszillator nach Anspruch 12, bei dem der Ein-Chip-IC und der piezoelektrische Resonator (X) in einem Gehäuse untergebracht sind.

14. Drahtloses Kommunikationsgerät, **dadurch gekennzeichnet, dass** es den Oszillator (20) gemäß Anspruch 13 enthält, und dass seine Operation auf dem Ausgangssignal der spannungsgesteuerten Oszillatorschaltung (28) basiert.

15. Verfahren zum Steuern des temperaturkompensierten Oszillators nach einem der Ansprüche 1 bis 5, aufweisend:
(a) Erkennen des Beginns der Stromversorgung der spannungsgesteuerten Oszillatorschaltung (28);
(b) Veranlassen, dass die Schaltmittel (SW1, SW1A) als Reaktion auf die Erkennung in Schritt (a) in den zweiten Zustand schalten; und
(c) Veranlassen, dass die Schaltmittel (SW1, SW1A) in den ersten Zustand zurückschalten, wenn eine vorgegebene Zeitspanne abgelaufen ist, nachdem die Schaltmittel (SW1, SW1A) in Schritt (b) in den zweiten Zustand geschaltet haben.

16. Verfahren nach Anspruch 15 zum Steuern des Oszillators nach Anspruch 5, ferner aufweisend:
(d) Erkennen des Beginns der Stromversorgung der Temperaturkompensationsschaltung (21);
(e) Veranlassen, dass das Ausgangsschaltmittel (22) als Reaktion auf die Erkennung in Schritt (d) in den zweiten Modus schaltet;
(f) Erkennen, dass die Stromversorgung der Temperaturkompensationsschaltung (21) beendet wird; und
(g) Veranlassen, dass das Ausgangsschaltmittel (22) als Reaktion auf die Erkennung in Schritt (f) in den ersten Modus zurückschaltet.

17. Verfahren zum Steuern des Oszillators nach Anspruch 5, ferner aufweisend:
(d) Erkennen des Beginns der Stromversorgung der Temperaturkompensationsschaltung (21);
(e) Veranlassen, dass das Ausgangsschaltmittel (22) als Reaktion auf die Erkennung in Schritt (d) in den zweiten Modus schaltet;
(f) Erkennen, dass die Stromversorgung der Temperaturkompensationsschaltung (21) beendet wird;
und
(g) Veranlassen, dass das Ausgangsschaltmittel (22) als Reaktion auf die Erkennung in Schritt (f) in den ersten Modus zurückschaltet.

18. Verfahren nach Anspruch 16 oder 17, bei dem dann, wenn die Stromversorgung der Temperaturkompensationsschaltung (21) beendet wird, die Stromversorgung der anderen Schaltungen des Oszillators, einschließlich der spannungsgesteuerten Oszillatorschaltung (28), jedoch mit Ausnahme des Ausgangsschaltmittels (22) ebenfalls beendet wird.

19. Verfahren nach einem der Ansprüche 15 bis 18, bei dem die Stromversorgung der spannungsgesteuerten Oszillatorschaltung (28) und der Temperaturkompensationsschaltung (21) gemäß eines extern bereitstellten Steuersignals (φST) beginnt und endet.

## Revendications

1. Oscillateur à compensation thermique comprenant :
un circuit (28) d'oscillation commandé en tension pour produire un signal de sortie d'oscillation dont la fréquence varie en fonction d'une tension de commande (Vc1, Vc2) appliquée ;
un circuit (21) de compensation thermique pour délivrer en sortie une tension (Vc1) de compensation thermique pour maintenir constante la fréquence indépendamment des variations de température ;
un moyen (23) de filtrage pour éliminer le bruit contenu dans la tension (Vc1) de compensation thermique ; et
un moyen (26) de commande d'alimentation pour commander l'alimentation électrique du circuit (21) de compensation thermique,
**caractérisé par :**
**le fait que** le moyen (26) de commande d'alimentation est apte à commander également l'alimentation électrique du circuit (28) d'oscillation commandé en tension ; et
un moyen (SW1A) de commutation sensible au fait que le moyen (26) de commande d'alimentation commence à alimenter en électricité le circuit (28) d'oscillation commandé en tension pour commuter momentanément, pendant une durée spécifiée, d'un premier état à un deuxième état, le moyen (SW1, SW1A) de commutation, dans le deuxième état, modifiant la caractéristique du moyen (23) de filtrage de façon à ce que le retard de signal provoqué par le moyen de filtrage soit sensiblement inférieur à ce qu'il est dans le premier état du moyen (SW1, SW1A) de commutation,
dans lequel le moyen (23) de filtrage est un filtre passe-bas ayant un élément (C) capacitif et une résistance (R), l'élément (C) capacitif peut être connecté par l'intermédiaire du moyen (SW1A) de commutation dans le premier état à une extrémité (B) de la résistance (R) et, dans le deuxième état, à l'autre extrémité (A) de la résistance (R).

2. Oscillateur suivant la revendication 1, dans lequel le moyen (SW1) de commutation comprend un commutateur connecté en parallèle au moyen (23) de filtrage, le premier état étant l'état OUVERT et le deuxième état étant l'état FERMÉ du commutateur.

3. Oscillateur suivant la revendication 1, dans lequel le moyen de filtrage comprend de multiples étages de filtres passe-bas, dans lesquels des éléments capacitifs sont connectés à des éléments résistifs par l'intermédiaire du moyen de commutation, et le moyen de commutation est apte à connecter, dans son premier état, une extrémité de chaque élément capacitif du côté de la sortie à tension compensée thermiquement de l'élément résistif correspondant, et dans son deuxième état, du côté de l'entrée à tension compensée thermiquement de l'élément résistif qui, parmi tous les éléments résistifs, est le plus proche du circuit (21) à compensation thermique.

4. Oscillateur suivant la revendication 1 ou 3, dans lequel des éléments d'inductance sont utilisés au lieu des éléments résistifs (R) dans le moyen (23) de filtrage.

5. Oscillateur suivant l'une quelconque des revendications 1 à 4, comprenant en outre :
un moyen (22) de commutation de sortie entre le circuit (21) de compensation thermique et le moyen (23) de filtrage, le moyen (22) de commutation de sortie étant apte à commuter entre un premier mode, dans lequel sa tension de sortie suit la tension (Vc1) de compensation thermique, et un deuxième mode, dans lequel la tension de sortie est maintenue au niveau de la tension (Vc1) de compensation thermique au moment où le premier mode est commuté au deuxième mode, le moyen (22) de commutation de sortie étant commandé par le moyen (26) de commande d'alimentation pour passer au premier mode lorsque l'alimentation électrique du circuit (21) de compensation thermique est mis en fonctionnement, et au deuxième mode, lorsque l'alimentation électrique du circuit (21) de compensation thermique est interrompue.

6. Oscillateur suivant l'une quelconque des revendications précédentes, comprenant en outre :
un circuit (25) de commande de tension sensible à un signal (φVC) de commande de fréquence fourni de l'extérieur pour délivrer en sortie une tension (Vc2) de commande de fréquence, le signal (φVC) de commande de fréquence représentant une fréquence souhaitée du signal de sortie d'oscillation ;
un additionneur (27) pour additionner l'une à l'autre la tension (Vc1) de compensation de température et la tension (Vc2) de commande de fréquence afin d'obtenir la tension (Vc1, Vc2) de commande ; et
un autre moyen (24) de filtrage pour éliminer le bruit contenu dans la tension (Vc2) de commande de fréquence.

7. Oscillateur suivant la revendication 6, dans lequel la fréquence de coupure du moyen (23) de filtrage est inférieure à celle de l'autre moyen (24) de filtrage.

8. Oscillateur suivant la revendication 6 ou 7, dans lequel l'autre moyen (24) de filtrage est constitué d'éléments résistifs et d'éléments capacitifs (C) ou est constitué d'éléments d'inductance et d'éléments capacitifs.

9. Oscillateur suivant l'une quelconque des revendications précédentes, dans lequel le moyen (26) de commande d'alimentation est apte à commander l'alimentation électrique du circuit (28) d'oscillation commandé en tension et du circuit (21) de compensation thermique sur la base d'un signal (φST) de commande fourni de l'extérieur.

10. Oscillateur suivant l'une quelconque des revendications précédentes, dans lequel le moyen (26) de commande d'alimentation est apte à mettre en fonctionnement l'alimentation électrique du circuit (28) d'oscillation commandé en tension et du circuit (21) de compensation thermique en même temps, et à interrompre également l'alimentation électrique de ces deux circuits en même temps.

11. Oscillateur suivant l'une quelconque des revendications précédentes, dans lequel le circuit (28) d'oscillation commandé en tension comprend un résonateur (X) piézoélectrique et un élément (Cv) à capacité variable dont la capacité varie en fonction de la tension (Vc1, Vc2) de commande.

12. Oscillateur suivant la revendication 11, dans lequel les parties constitutives dont est formé l'oscillateur, à l'exception du résonateur (X) piézoélectrique, sont réalisées sous la forme d'un circuit intégré à une seule puce.

13. Oscillateur suivant la revendication 12, dans lequel le circuit intégré à une seule puce et le résonateur (X) piézoélectrique sont logés dans un boîtier.

14. Dispositif de communication sans fil **caractérisé par le fait qu'**il contient l'oscillateur (20) suivant la revendication 13 et en ce que son fonctionnement s'effectue à partir du signal de sortie du circuit (28) d'oscillation commandé en tension.

15. Procédé de commande de l'oscillateur à compensation thermique suivant l'une quelconque des revendications 1 à 5, consistant à :
(a) détecter le début de l'alimentation électrique du circuit (28) d'oscillation commandé en tension,
(b) faire en sorte que le moyen (SW1, SW1A) de commutation commute dans le deuxième état en réponse à une détection effectuée à l'étape (a), et
(c) faire en sorte que le moyen (SW1, SW1A) de commutation commute de nouveau au premier état lorsqu'une durée spécifiée s'est écoulée après que le moyen (SW1, SW1A) de commutation a commuté au deuxième état lors de l'étape (b).

16. Procédé suivant la revendication 15, pour commander l'oscillateur suivant la revendication 5, consistant en outre à :
(d) détecter le début de l'alimentation électrique du circuit (21) de compensation thermique ;
(e) faire en sorte que le moyen (22) de commutation de sortie commute dans le deuxième mode en réponse à une détection effectuée à l'étape (d) ;
(f) détecter le fait que l'alimentation électrique du circuit (21) de compensation thermique est interrompue ; et
(g) faire en sorte que le moyen (22) de commutation de sortie commute de nouveau dans le premier mode en réponse à une détection effectuée à l'étape (f).

17. Procédé de commande de l'oscillateur à compensation thermique suivant la revendication 5, consistant à :
(d) détecter le début de l'alimentation électrique du circuit (21) de compensation thermique ;
(e) faire en sorte que le moyen (22) de commutation de sortie commute dans le deuxième mode en réponse à une détection effectuée à l'étape (d) ;
(f) détecter le fait que l'alimentation électrique du circuit (21) de compensation thermique est interrompue ; et
(g) faire en sorte que le moyen (22) de commutation de sortie commute de nouveau dans le premier mode en réponse à une détection effectuée à l'étape (f).

18. Procédé suivant la revendication 16 ou 17, dans lequel, lorsque l'alimentation électrique du circuit (21) de compensation thermique est interrompue, l'alimentation électrique d'autres circuits de l'oscillateur, y compris le circuit (21) d'oscillation commandé en tension, à l'exception du moyen (22) de commutation de sortie, est également interrompue.

19. Procédé suivant l'une quelconque des revendications 15 à 18, dans lequel l'alimentation électrique du circuit (28) d'oscillation commandée en tension et du circuit (21) de compensation thermique est commencée et interrompue en fonction d'un signal (φST) de commande fourni de l'extérieur.
